# EUROPÄISCHE PATENTSCHRIFT

(11) **EP 1 393 604 B1**
(45) Veröffentlichungstag und Bekanntmachung des Hinweises auf die Patenterteilung: **12.01.2011**
(21) Anmeldenummer: 02769472.8
(22) Anmeldetag: 08.05.2002
(51) Int. Cl.: H05K 3/34, H01R 9/16

(54) **LEITERPLATTE MIT EINER DARAUF AUFGEBRACHTEN KONTAKTHÜLSE**
PRINTED CIRCUIT BOARD COMPRISING A CONTACT SLEEVE THAT IS MOUNTED THEREON
CARTE DE CIRCUITS IMPRIMES SUR LAQUELLE UN CONNECTEUR FEMELLE EST MONTE

(30) Priorität: 15.05.2001 DE 10123684
(43) Veröffentlichungstag der Anmeldung: 03.03.2004
(73) Patentinhaber: Endress + Hauser GmbH + Co. KG, 79689 Maulburg (DE)
(72) Erfinder: BIRGEL, Dietmar, 79650 Schopfheim (DE); HAUPTVOGEL, Karl-Peter, F-68870 Bartenheim (FR); BRUTSCHIN, Wolfgang, 79650 Schopfheim (DE); MÜLLER, Alexander, 79689 Maulburg (DE)
(74) Vertreter: Andres, Angelika Maria
(86) Internationale Anmeldenummer: PCT/EP2002/005065
(87) Internationale Veröffentlichungsnummer: WO 2002/093992

(56) Entgegenhaltungen:
- DE-U- 9 210 077
- US-A- 4 505 531
- US-A- 6 140 977

## Beschreibung

Die Erfindung betrifft eine Leiterplatte mit einer darauf aufgebrachten Kontakthülse.

Kontakthülsen sind in der Regel metallische Hohlzylinder. Sie dienen z.B. als Buchsen für Bananenstecker. Es können aber auch mehrere Kontakthülsen nebeneinander angeordnet sein, in die dann ein Stecker mit entsprechender Anzahl Steckkontakten einbringbar ist.

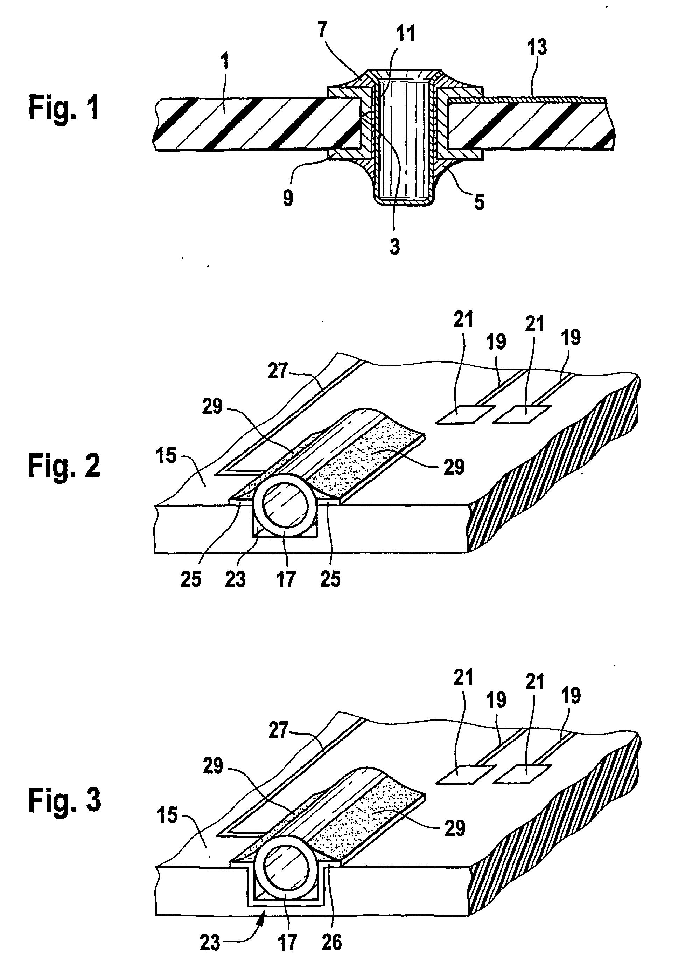

Kontakthülsen werden üblicherweise, wie in Fig. 1 dargestellt, in eine eine Leiterplatte 1 durchdringende Bohrung 3 eingebracht und an deren beiden Enden jeweils durch eine Lotverbindung 5, 7 mit der Leiterplatte 1 verbunden. Eine zylindrische Mantelfläche der Bohrung 3 und endseitig an die Bohrung angrenzende ringscheibenförmige Bereiche der Leiterplatte 1 sind mit einer Metallisierung 9 versehen. Durch die Lotverbindungen 5, 7 besteht eine mechanische Befestigung der Kontakthülse 11 und eine elektrische Verbindung zwischen der Kontakthülse 11 und der Metallisierung 9 der Leiterplatte 1. Die Metallisierung 9 ist über mindestens eine auf der Leiterplatte verlaufende Leiterbahn 13 elektrisch angeschlossen.

Üblicherweise werden die Leiterplatten manuell mit den Kontakthülsen bestückt und die Lotverbindungen werden entweder ebenfalls von Hand oder in einem Wellenlötbad hergestellt.

Moderne elektrische Geräte, insb. Meßgerät, weisen in der Regel mindestens eine Leiterplatte auf, auf der elektronische Bauteile angeordnet sind. Diese Bauteile müssen mechanisch auf der Leiterplatte befestigt werden und elektrisch an in oder auf der Leiterplatte verlaufende Leitungen angeschlossen werden. Zur Reduktion von Herstellungskosten werden vorzugsweise oberflächenmontierbare Bauteile, sogenannte 'Surface Mounted Devices' - kurz SMD Bauteile eingesetzt. SMD Bauteile benötigen für deren Montage keine Leiterplattenlöcher, sondern werden mit ihren Kontakten direkt an vorgesehenen Anschlüssen angelötet. SMD-Bauteile können mit Bestückungsautomaten maschinell auf der Leiterplatte plaziert werden.

Typischerweise wird in einem ersten Schritt an allen Orten, an denen nachfolgend Bauteile positioniert werden, im Siebdruckverfahren eine Lotpaste auf die Leiterplatte aufgebracht. Ein Ort an dem Lot aufgebracht ist bzw. an dem nach Beendigung des Fertigungsprozesses eine Lötverbindung besteht ist nachfolgend als Lötstelle bezeichnet.

In einem nächsten Schritt werden die Leiterplatten maschinell mit den Bauteilen bestückt. Die bestückten Leiterplatten werden in einen Ofen, insb. einen Reflowofen, eingebracht. Der Lötvorgang wird in einem Ofen, z.B. in einer Schutzgasatmosphäre, vorgenommen, indem ein lotspezifischer Temperaturzyklus durchlaufen wird.

Heute sind die meisten elektronischen Bauteile als SMD-Bauteile erhältlich, was zu einer erheblichen Reduktion der Herstellkosten von elektronischen Geräten geführt hat. Leider sind immer noch einige Bauteile nicht zusammen mit SMD-Bauteilen in einem Arbeitsgang montierbar und anschließbar. Zu diesen Bauteilen zählen die oben genannten Kontakthülsen. Die manuelle Bestückung und der Anschluß dieser Bauteile bedeutet einen hohen zusätzlichen Aufwand.

Eine nach dem Oberbegriff des Anspruchs 1 bekannte Leiterplatte ist in US-A-6140977 offenbart.

Es ist eine Aufgabe der Erfindung eine Leiterplatte mit einer Kontakthülse anzugeben, bei der die Kontakthülse wie ein SMD-Bauteil elektrisch anschließbar ist.

Hierzu besteht die Erfindung in einer Leiterplatte mit
- einer auf einer Oberseite der Leiterplatte vorgesehen taschenförmige Ausnehmung,
- einer an die Ausnehmung angrenzenden Metallisierung,
   -- die an eine auf der Leiterplatte verlaufende Leiterbahn angeschlossen ist, und
- einer in die taschenförmige Ausnehmung eingelegten Kontakthülse,
   -- die mittels einer Lotverbindung mechanisch befestigt und elektrisch an die Metallisierung angeschlossen ist.

Gemäß einer Ausgestaltung ist die Ausnehmung in die Leiterplatte eingefräst.

Gemäß einer ersten Ausgestaltung ist die Metallisierung durch an die Ausnehmung angrenzende Kupferpads gebildet.

Gemäß einer zweiten Ausgestaltung ist die Metallisierung eine auf der Oberfläche der Ausnehmung und einem daran angrenzenden Bereich aufgebrachte metallische Beschichtung.

Weiter besteht die Erfindung in einem Verfahren zur Herstellung einer solchen Leiterplatte, bei dem
- Lot maschinell auf die Leiterplatte aufgebracht wird,
- die Kontakthülse zusammen mit SMD-Bauteilen mittels eines Bestückungsautomaten auf die Leiterplatte aufgesetzt wird, und
- die bestückte Leiterplatte in einen Ofen eingebracht wird, indem die Lotverbindungen zu den SMD-Bauteilen und der Kontakthülse durch
   Wärmeeinwirkung hergestellt werden.

Dadurch, daß die Kontakthülse nicht, wie bei Stand der Technik üblich durch die Leiterplatte hindurch gesteckt wird, sondern in eine Ausnehmung auf der Oberfläche der Leiterplatte eingelegt ist, kann sie wie ein SMD-Bauteil behandelt werden. Das bedeutet, daß sie maschinell auf die Leiterplatte aufgebracht werden kann. Das Lot wird also zusammen mit dem Lot für SMD-Bauteile maschinell aufgebracht, die Leiterplatte wird komplett mit Kontakthülsen und SMD-Bauteilen maschinell bestückt und es können viele Leiterplatten hergestellt und über Förderbänder in einen Ofen eingebracht werden, indem gleichzeitig viele Leiterplatten behandelt werden.
Hierdurch ist eine erhebliche Kostenersparnis möglich.

Die Erfindung und weitere Vorteile werden nun anhand der Figur der Zeichnung, in der drei Ausführungsbeispiele dargestellt ist, näher erläutert; gleiche Elemente sind in den Figuren mit gleichen Bezugszeichen versehen.
Fig. 1 zeigt schematisch eine Leiterplatte mit einer Kontakthülse gemäß dem Stand der Technik;
Fig. 2 zeigt schematisch eine Leiterplatte mit einer erfindugsgemäß aufgebrachten und angeschlossenen Kontakthülse, bei der die Leiterplatte beidseits einer Ausnehmung für die Kontakthülse eine Metallisierung aufweist;
Fig. 3 zeigt schematisch eine Leiterplatte mit einer erfindugsgemäß aufgebrachten und angeschlossenen Kontakthülse, bei der die Leiterplatte beidseits einer Ausnehmung für die Kontakthülse und in der Ausnehmung eine Metallisierung aufweist;
Fig. 4 zeigt schematisch eine Leiterplatte mit drei Erfindungsgemäß aufgebrachten und angeschlossenen Kontakthülsen; und
Fig. 5 zeigt schematisch einen zugehörigen Stecker mit drei Kontakten.

Fig. 2 zeigt schematisch eine Leiterplatte 15 mit einer erfindungsgemäß aufgebrachten und angeschlossenen Kontakthülse 17.

Die Kontakthülse 17 ist ein metallischer Hohlzylinder und besteht z.B. aus Kupfer.

Die Leiterplatte 15 ist z.B. eine handelsübliche starre Leiterplatte, z.B. aus einem Isolierstoff auf Epoxidharzbasis. Leiterbahnen 19 der Leiterplatte 15 bestehen üblicherweise aus Kupfer und weisen dort, wo ein Anschluß erfolgen soll freiliegende Kupferpads 21 auf. In Fig. 2 sind zwei für den Anschluß eines SMD-Bauteils geeignete Kupferpads 21 exemplarisch dargestellt.

Auf einer Oberseite der Leiterplatte 15 ist eine taschenförmigen Ausnehmung 23 vorgesehen. Die taschenförmigen Ausnehmung 23 ist z.B. in die Leiterplatte 15 eingefräst.

An die Ausnehmung 23 grenzt eine Metallisierung 25 an. Die Metallisierung 25 können z.B. auf die Leiterplatte 15 aufgebrachte an die Ausnehmung 23 angrenzende Kupferpads sein. Dies ist in Fig. 2 dargestellt.

Ebenso kann aber auch die Oberfläche der Ausnehmung 23 sowie ein daran angrenzender Bereich der Oberfläche der Leiterplatte 15 mit einer Metallisierung 26 in Form einer metallischen Beschichtung versehen sein. Diese Ausführungsform ist in Fig. 3 dargestellt. Abgesehen von der Metallisierung 26 ist die in Fig. 3 dargestellte Ausführungsform identisch zu der in Fig. 2 dargestellten Ausführungsform.

Die Metallisierungen 25, 26 werden z.B. eletrochemisch oder galvanisch aufgebracht.

An die Metallisierung 25, 26 ist eine auf der Leiterplatte 15 verlaufende Leiterbahn 27 angeschlossen.

Die Kontakthülse 17 ist der Länge nach in die Ausnehmung 23 eingelegt und mittels einer Lotverbindung 29 mechanisch befestigt und elektrisch an die Metallisierung 25, 26 angeschlossen.

Auf den Kupferpads 21 und auf der Metallisierung 25, 26 kann gegebenenfalls eine Anschlußmetallisierung vorgesehen sein. Die Anschlußmetallisierung besteht z.B. aus einer Nickelschicht und einer Goldschicht. Das Nickel wird galvanisch, das Gold chemisch aufgebracht. Dabei ist die Nickelschicht zwischen dem Kupferpad 21 bzw. der Metallisierung 25 und der Goldschicht anzuordnen. Sie dient als Diffusionsbarriere und verhindert ein abwandern von Kupfer in die Goldschicht. Diese Art der Oberflächenverbesserung wird häufig bei Lötverbindungen eingesetzt.

Alternativ kann eine Heißluftverzinnung zur Verbesserung der Löteigenschaften vorgenommen werden. Dabei wird Zinn auf die Kupferpadoberfläche bzw. die Oberfläche der Metallisierung 25 aufgebracht und mittels Heißluft aufgeschmolzen. Das flüssige Zinn bildet eine sehr plane Oberfläche aus, die für einen nachfolgenden Lötvorgang vorteilhaft ist. Das Verfahren wird auch als Hot-Air-Leveling (HAL) bezeichnet.

Kontakte von handelsüblichen SMD-Bauteilen bestehen aus einer Zinn-Blei-Legierung. Besonders geeignet ist ein Lot das einen Silberanteil aufweist. Sehr gute Ergebnisse werden mit einem Zinn-Silber-Lot erzielt. Das Lot ist vorzugsweise bleifrei. Blei weist einen niedrigen Schmelzpunkt auf und führt dazu, daß mit bleihaltigen Loten nur bei niedrigen Temperaturen stabile Verbindungen herstellbar sind. Ein Zinn-Blei-Lot weist eine Schmelzpunkt von ca. 180°C auf, bei einem Zinn-Silber-Lot liegt der Schmelzpunkt dagegen bei ca. 220°C.

Hergestellt wird eine solche erfindungsgemäße Leiterplatte 15 vorzugsweise maschinell. Es wird das Lot, z.B. im Siebdruckverfahren, maschinell auf die entsprechenden Stellen auf der Leiterplatte 15, hier den Kupferpads 21 und der Metallisierung 25, 26 aufgebracht. Anschließend wird die Leiterplatte 15 mittels eines Bestückungsautomaten mit allen gewünschten SMD-Bauteilen und der Kontakthülse 17 bestückt. Selbstverständlich können auch mehrere Kontakthülsen auf einer Leiterplatte vorgesehen sein.

Aufgrund der erfindungsgemäßen Ausbildung ist die Kontakthülse 17 wie ein SMD-Bauteil behandelbar.

Ein Bauteil ist als SMD-Bauteil behandelbar, wenn alle Kontakte, die an eine Leiterplatte anzuschließen sind auf einer Seite des Bauteils angeordnet sind und auf planen Oberflächen aufliegen. Damit kann die Bestückung und die Verbindung der Leiterplatte 15 mit der Kontakhülse 17 maschinell in Serienfertigung erfolgen.

Aufgrund der Naßklebekraft des Lotes sind alle Bauteile auf der Leiterplatte 15 fixiert und die Leiterplatte 15 kann sofort nach deren Bestückung transportiert werden. Damit ist es möglich, die Leiterplatten 15 während des gesamten Herstellprozesses über Förderbänder zu transportieren. Vibrationen, wie sie bei dieser Transportart zwangsläufig auftreten führen nicht zu einem verrutschen oder gar zum Verlust von Bauteilen. Gegebenenfalls erforderliche weitere Arbeitsgänge können sofort ausgeführt werden.

Die bestückte Leiterplatte 15 wird dann in einen Ofen, vorzugsweise einem Reflow-Lötofen eingebracht, indem die Lotverbindungen zu den SMD-Bauteilen und der Kontakthülse 17 durch Wärmeeinwirkung hergestellt werden. Aufgrund der Naßklebekraft des Lotes kann dies unmittelbar im Anschluß an die Bestückung der Leiterplatte 15 mit den Bauteilen und über ein Förderband erfolgen. Im Ofen wird ein Temperaturzyklus durchlaufen, durch den eine elektrische und mechanische Lotverbindung zwischen jedem Bauteil und der Leiterplatte 15 entsteht.

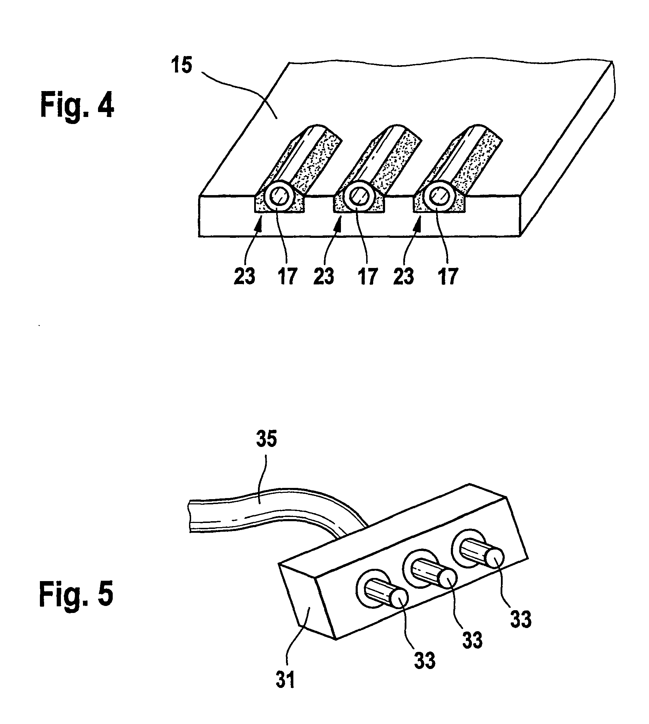

Fig. 4 zeigt zeigt schematisch eine Leiterplatte 15 mit drei erfindungsgemäß aufgebrachten und angeschlossenen Kontakthülsen 17 und Fig. 5 einen zugehörigen Stecker 31 mit drei Kontakten 33. Die Kontakte 33 sind z.B. Metallstifte, die im Inneren des Steckers 31 mit Adern eines Kabels 35 verbunden sind. Die drei Kontakthülsen 17 sind nebeneinander angeordnet und enden bündig mit einer Außenkante der Leiterplatte 15.

Mehrere nebeneinander anzuordnende Kontakthülsen 17 können genau wie SMD-Widerstände in einem Gurt zusammengefaßt werden und mit einer Bestückungsmaschine auf die Leiterplatte 15 aufgesetzt werden.

Die Leiterplatte 15 kann z.B. in ein in Fig. 4 nicht dargestelltes Gehäuse derart eingesetzt werden, daß die Kontakthülsen 17 von außen durch entsprechende Öffnungen im Gehäuse zugänglich sind. Beim Aufsetzen des Steckers 31 auf das Gehäuse dringen die Kontakte 33 in die Kontakthülsen 17 ein und bewirken einen elektrischen Anschluß.

## Patentansprüche

1. Leiterplatte mit
- einer auf einer Oberseite der Leiterplatte (15) vorgesehenen Ausnehmung (23),
- einer an die Ausnehmung (23) angrenzenden Metallisierung (25, 26),
-- die an eine auf der Leiterplatte (15) verlaufende Leiterbahn (27) angeschlossen ist, und
- einer in die Ausnehmung (23) eingelegten Kontakthülse (17),
-- die mittels einer Lotverbindung (29) mechanisch befestigt und elektrisch an die Metallisierung (25,26) angeschlossen ist, **dadurch gekennzeichnet, daß** die Ausnehmung (23) taschenförmig ist.

2. Leiterplatte nach Anspruch 1, bei der die taschenförmige Ausnehmung (23) in die Leiterplatte (15) eingefräst ist.

3. Leiterplatte nach Anspruch 1, bei der die
Metallisierung (25) durch an die Ausnehmung (23) angrenzende Kupferpads gebildet ist.

4. Leiterplatte nach Anspruch 1, bei der die
Metallisierung (26) eine auf der Oberfläche der Ausnehmung (23) und einem daran angrenzenden Bereich aufgebrachte metallische Beschichtung ist.

5. Verfahren zur Herstellung einer Leiterplatte
gemäß einem der vorangehenden Ansprüche, bei dem
- Lot maschinell auf die Leiterplatte (15) aufgebracht wird,
- die Kontakthülse (17) zusammen mit SMD-Bauteilen mittels eines Bestückungsautomaten auf die Leiterplatte (15) aufgesetzt wird, und
- die bestückte Leiterplatte (15) in einen Ofen eingebracht wird, indem die Lotverbindungen zu den SMD-Bauteilen und der Kontakthülse (17) durch Wärmeeinwirkung hergestellt werden.

## Claims

1. Printed circuit board with
- a recess (23) provided on the upper surface of the printed circuit board (15)
- metalization (25, 26) adjacent to the recess (23)
-- said metalization being connected to a track (27) on the printed circuit board (15), and
- a contact sleeve (17) inserted into the recess (23)
-- said sleeve being mechanically secured with a solder joint (29) and electrically connected to the metalization (25, 26), **characterized in that** the recess (23) is pocket-like.

2. Printed circuit board as per Claim 1, where the pocket-like recess (23) is milled into the printed circuit board (15).

3. Printed circuit board as per Claim 1, where the metalization (25) is formed by a copper path adjacent to the recess (23).

4. Printed circuit board as per Claim 1, where the metalization (26) constitutes a metal coating on the surface of the recess (23) and an adjacent area.

5. Method for producing a printed circuit board as per one of the previous claims, in which:
- soldering metal is applied to the printed circuit board (15) by machine.
- the contact sleeve (17) along with SMDs are fitted on the printed circuit board (15) by a placement machine.
- the assembled printed circuit board (15) is inserted into a furnace in which the solder joints for the SMDs and the contact sleeve (17) are established by the effect of heat in the furnace.

## Revendications

1. Carte de circuit imprimé avec
- un évidement (23) prévu sur une face supérieure de la carte de circuit imprimé (15),
- une métallisation (25, 26) contiguë à l'évidement (23),
-- laquelle est connectée à la piste (27) traversant la carte de circuit imprimé (15), et
- une douille de contact (17) introduite dans l'évidement (23),
-- laquelle est fixée mécaniquement au moyen d'une connexion soudée (29) et électriquement à la métallisation (25, 26), **caractérisée en ce que** l'évidement (23) est en forme de poche.

2. Carte de circuit imprimé selon la revendication 1, pour laquelle l'évidement (23) en forme de poche est fraisé dans la carte de circuit imprimé (15).

3. Carte de circuit imprimé selon la revendication 1, pour laquelle la métallisation (25) est formée par la piste de cuivre contiguë à l'évidement (23).

4. Carte de circuit imprimé selon la revendication 1, pour laquelle la métallisation (26) est un revêtement métallique appliqué sur la surface de l'évidement (23) et une zone contiguë à l'évidement.

5. Procédé destiné à la fabrication d'une carte de circuit imprimé selon l'une des revendications précédentes, pour lequel
- la soudure est appliquée à la machine sur la carte de circuit imprimé (15)
- la douille de contact (17) est implantée conjointement avec des composants CMS au moyen d'automates à équiper les circuits imprimés sur la carte de circuit imprimé (15), et
- la carte de circuit imprimé (15) équipée est introduite dans un four, dans lequel les liaisons soudées avec les composants CMS et la douille de contact (17) sont réalisées par l'action de la chaleur.
